Europäisches Patentamt

European Patent Office

Office européen des brevets

(11) Publication number: **0 060 676 B1**

(12) **EUROPEAN PATENT SPECIFICATION**

(45) Date of publication of patent specification: **25.07.90**

(51) Int. Cl.⁵: **H 01 L 21/324, H 01 L 21/322, H 01 L 29/167**

(21) Application number: **82301212.5**

(22) Date of filing: **10.03.82**

(54) **A method for the production of a semiconductor device comprising annealing a silicon wafer.**

(30) Priority: **11.03.81 JP 35021/81**
**11.03.81 JP 35022/81**
**11.03.81 JP 35023/81**
**11.03.81 JP 35024/81**
**11.03.81 JP 35025/81**

(43) Date of publication of application:
**22.09.82 Bulletin 82/38**

(45) Publication of the grant of the patent:
**25.07.90 Bulletin 90/30**

(84) Designated Contracting States:
**DE FR GB NL**

(73) Proprietor: **FUJITSU LIMITED**
**1015, Kamikodanaka Nakahara-ku**
**Kawasaki-shi Kanagawa 211 (JP)**

(72) Inventor: **Imaoka, Kazunori**
**3-17-3-304, Higashinogawa Komae-shi**
**Tokyo 201 (JP)**
Inventor: **Kozawa, Hideaki**
**2-6-203, Wakabadai Asahi-ku**
**Yokohama-shi Kanagawa 241 (JP)**
Inventor: **Hiraguchi, Takao**
**19-1, Aza Suginode Sakuragawa Mizusawa-shi**
**Iwate, 023 (JP)**

(74) Representative: **Sunderland, James Harry et al**
**HASELTINE LAKE & CO Hazlitt House 28**
**Southampton Buildings Chancery Lane**
**London WC2A 1AT (GB)**

(56) References cited:
**FR-A-2 204 046**

**APPLIED PHYSICS LETTERS, vol. 49, no. 5, May 1978, pages 2711-2716, American Institute of Physics, New York, US; C. PLOUGONVEN et al.: "Ring-shaped stacking faults induced by oxide precipitates in silicon"**
**APPLIED PHYSICS LETTERS, vol. 37, no. 7, 1st October 1980, pages 622-624, American**

(56) References cited:

**Institute of Physics, New York, US; K. NAGASAWA et al.: "A new intrinsic gettering technique using microdefects in Czochralski silicon crystal: A new double preannealing technique"**

56 References cited:

PATENTS ABSTRACTS OF JAPAN, vol. 6, no. 147 (E-123)1025r, 6th August 1982; & JP - A - 57 72 340 (TOKYO SHIBAURA DENKI K.K.) 06-05-1982

IBM TECHNICAL DISCLOSURE BULLETIN, vol. 24, no. 7A, December 1981, pages 3420-3421, New York, US; C.A. BARILE et al.: "Furnace ramping to reduce slip dislocation generation on large semiconductor wafers"

SOLID STATE TECHNOLOGY, vol. 24, no. 7, July 1981, pages 55-61, Port Washington, New York, US; R.A. CRAVEN et al.: "Internal gettering in silicon"

## Description

The present invention relates to methods for production of semiconductor devices.

The intrinsic gettering effect is effective to produce and maintain a denuded zone which is fairly free from crystalline defects and which is employed as an active layer of a semiconductor device. This known effect is based on the principle that an internal region of a semiconductor wafer containing a large quantity or concentration of crystalline defects has a capability for absorbing impurities, e.g. oxygen, carbon, et al., each of which is a possible nucleus for production of crystalline defects, which are contained in a surface region of the semiconductor wafer, leaving the surface region of the semiconductor wafer in a defect free condition, or leaving the surface region, having a thickness in the range from several micrometers to several tens of micrometers, of the semiconductor wafer as a denuded zone.

It is known that a smaller thickness of a denuded zone located in a shallow region of a semiconductor wafer together with a higher concentration of crystalline defects contained in the deep or internal region of a semiconductor wafer is effective to cause an increased intrinsic gettering effect function. Therefore, simply from the viewpoint of the intrinsic gettering effect, a smaller thickness is preferable for a denuded zone. Incidentally, however, since the thickness of a denuded zone is required to exceed the thickness of an active layer (which latter thickness is, for example, 5 micrometers for a bipolar transistor and 3 micrometers for a MOS transistor) the thickness of a denuded zone is required to be approximately 10 micrometers for a bipolar transistor and 6 micrometers for a MOS transistor.

Previously, two different methods have been available for producing a semiconductor wafer which is provided with the intrinsic gettering effect, or which has a shallow or surface region consisting of a denuded zone free of crystalline defects and a deep or internal region containing crystalline defects large in size. One method is a two-step method which consists of a first step in which a semiconductor wafer containing impurities, e.g. oxygen, carbon et el., is annealed at a relatively low temperature in the range of 600°C to 900°C for the purpose of producing a high concentration of defect nuclei in the semiconductor wafer, and a second step in which the semiconductor wafer is annealed at a relatively high temperature in excess of 1,000°C for the purpose of causing the high concentration of defect nuclei to mature into a high concentration of crystalline defects.

The other method is a three-step method which offers an improvement over the two-step method. The three-step method consists of (a) a first step in which a semiconductor wafer, produced employing the Czochralski method and which contains impurities, e.g. oxygen, to a concentration in the range 0.5 to $2.0 \times 10^{18}$/cm$^3$, is annealed for approximately 20 hours in nitrogen gas at a high temperature of approximately 1,100°C for the purpose of diffusing the impurities out of a shallow region or a surface region of the semiconductor wafer, (b) a second step in which the seimconductor wafer is annealed for approximately 40 hours in nitrogen gas at a relatively low temperature in an approximate temperature range of 600°C to 900°C for the purpose of causing the impurities remaining in a deep region or an internal region of the semiconductor wafer to mature into a high concentration of defect nuclei, leaving the shallow region or the surface region of the semiconductor wafer in a condition in which it contains no impurities or in a defect-free condition, and (c) a third step in which the semiconductor wafer is annealed for approximately 20 hours in nitrogen gas at a relatively high temperature of approximately 1,050°C for the purposes (i) of causing the high concentration of defect nuclei to mature into a high concentration of crystalline defects in the deep region or the internal region of the semiconductor wafer, and (ii) of producing a denuded zone in the shallow region or the surface region.

Each previously available method for production of a semiconductor wafer which offers the intrinsic gettering effect has drawbacks as described below.

The first drawback is that an extremely long time is required. Specifically, in the case of the three-step method, approximately 80 hours are required, which is too long, particularly from the practical point of view. Albeit that the two-step method needs a shorter time, the quality of the denuded zone produced employing the two-step method is very unsatisfactory in comparison with the quality of the denuded zone produced employing the three-step method.

The second drawback is caused by the fact that a protection layer employed affords an unsatisfactory degree of protection. The protection layer covers the surface of a semiconductor wafer during a period in which one of the foregoing methods (for production of a semiconductor wafer which offers the intrinsic gettering effect) is employed, for the purpose of inhibiting the appearance of surface defects particularly in a surface region of the semiconductor wafer. This unsatisfactory degree of protection of the surface of the semiconductor wafer results in a requirement for an additional process step to remove the surface region containing surface defects which are not inhibited.

The third drawback is an unsatisfactory degree of control of the thickness of the denuded zone. In other words, it is not necessarily easy to control the thickness of the denuded zone produced employing any of the foregoing methods, in particular because this control is influenced by the concentration of oxygen contained in a semiconductor wafer.

The fourth drawback is a possibility of a semiconductor wafer warping during execution of the foregoing methods as a result of the rather high temperature required.

The fifth drawback is a possibility that a denuded zone once produced in a semiconductor wafer is rather easily destroyed during later thermal processes which inevitably are required in the overall process for production of a semiconductor device.

The sixth drawback is that only a rather unsatisfactory degree of intrinsic gettering effect can be expected from any semiconductor wafer produced employing any of the methods based on annealing processes, particularly in a case in which a bipolar semiconductor is produced in such a semiconductor wafer.

According to the present invention there is provided a method for production of a semiconductor device possessed of the intrinsic gettering effect, the method comprising annealing a silicon wafer, characterised in that at least one annealing process is effected in which annealing temperature is increased from a first temperature in the range 500°C to 900°C to a second temperature in the range 950°C to 1,300°C, at a rate not exceeding 14°C/min.

It is particularly effective, for an Si wafer containing oxygen to a concentration in excess of $1.5\times10^{18}/cm^3$, that the temperature increase rate be selected from the range 5 to 14°C/min for the or the first such annealing process.

Incidentally, it is particularly effective, for an Si wafer containing oxygen to a concentration not exceeding $1.5\times10^{18}/cm^3$, that the temperature increase rate be selected from the range not exceeding 5°C/min for the or the first such annealing process.

A method for production of a semiconductor device in accordance with one embodiment of the present invention provides that, before one or more such annealing processes is or are applied to the Si wafer containing oxygen to a concentration in excess of $1.5\times10^{18}/cm^3$, a preliminary step is effected in which the Si wafer is annealed at a temperature in excess of 950°C for a period in excess of 10 min.

A method for production of a semiconductor device in accordance with another embodiment of the present invention includes one (or more) thermal step(s) which is applied to an Si wafer having a denuded zone therein and of which the original or major purposes are to produce one or more semiconductor device elements in the foregoing Si wafer, (each of) the thermal step(s) being such an annealing process, with an increasing temperature, or an annealing process with a decreasing temperature, decreasing from a temperature in the range 950 to 1,300°C to a temperature in the range of 500 to 900°C.

It is preferable that the temperature decrease rate be in the range 5 to 14°C/min or less.

A method for production of a semiconductor device in accordance with another embodiment of the present invention includes a first step in which an Si wafer containing oxygen to a concentration in excess of $1.5\times10^{18}/cm^3$ is annealed employing such an annealing process in which the annealing temperature is increased at a rate not exceeding 5°C/min and a second step in which an epitaxial layer containing one or more impurities of one conductivity type and having a thickness in excess of 2 micrometers is grown on the Si wafer.

It is preferable for the first step to be conducted a plurality of times and for the temperature increase rate for the first such annealing process of the first step to be less than for later such annealing processes of the first step.

A modification of this embodiment of the present invention, directed at the production of a bipolar transistor, is available. This method, for production of a bipolar transistor, wherein the silicon wafer contains oxygen to a concentration in excess of $1.5\times10^{18}/cm^3$, wherein the said at least one annealing process is conducted under the condition that annealing temperature is increased from a first temperature in the range of 500°C to 900°C to a second temperature in the range of 950°C to 1,300°C at a rate not exceeding 5°C/min., and thereafter a thin silicon epitaxial layer containing at least one impurity, having one conductivity type, is grown on the silicon wafer, then at least one impurity, having the said one conductivity type, is introduced in a high concentration into a selected region of the top portion of the thin silicon epitaxial layer for the purpose of producing a buried layer, and then a silicon epitaxial layer containing at least one impurity, having the said one conductivity type, and having a thickness in excess of 2 micrometers, is grown on the thin silicon epitaxial layer.

An embodiment of the present invention provides a method for production of an Si wafer having a shallow or surface region which is a denuded zone and a deep or internal region, underlying the shallow or surface region, containing a high concentration of crystalline defects large in size, with good control of the thickness of the denuded zone. Improved control of the thickness of the denuded zone can be provided in particular for an Si wafer having a high concentration of oxygen in excess of $1.5\times10^{18}/cm^3$.

An embodiment of the present invention provides a method effective to maintain a denuded zone once produced in an Si wafer, even during a later thermal process included in the overall process for production of a semiconductor device.

Reference is made, by way of example, to the accompanying drawings, in which:—

Figure 1 is a graph illustrating the relationship between annealing temperature and annealing time for an annealing process included in a method for production of an Si wafer offering the intrinsic gettering effect in accordance with one embodiment of the present invention,

Figures 2(a) to (f) are graphs which illustrate the relationships between the size and the concentration of crystalline defects or the nuclei thereof existing in a deep or internal region of an Si wafer, and which together show the progress of growth of such nuclei of crystalline defects into crystalline defects,

Figure 3 is a graph illustrating the relationship between nucleation rate and annealing temperature,

Figure 4 is a graph illustrating the relationship between decrease in oxygen concentration $\Delta$ [Oi] and annealing temperature T°C, the relationship being determined by an experiment which is described in this specification.

Figure 5 is a graph illustrating the relationship between thickness of a denuded zone and annealing temperature increase rate for an Si wafer having an oxygen concentration in excess of $1.5 \times 10^{18}/cm^3$, the relationship being determined by an experiment which is described in this specification.

Figure 6 is a graph illustrating the temperature vs. time tendency of thermal cycles of a method in accordance with an embodiment of the present invention,

Figure 7 is a graph illustrating the temperature vs. time tendency of thermal cycles of a method in accordance with an embodiment of the present invention.

Figure 8 is a graph illustrating relationships between thickness of a denuded zone and length of an initial high temperature annealing period, shown with annealing temperature at a parameter, the relationship being determined by an experiment which is described in this specification.

Figure 9 is a graph illustrating the temperature vs. time tendency of the thermal cycles of a method in accordance with an embodiment of the present invention,

Figure 10(a) is a cross-sectional view of an Si wafer showing its condition after completion of a first step of a method in accordance with an embodiment of the present invention.

Figure 10(b) is a cross-sectional view of an Si wafer showing its condition after completion of a second step of a method in accordance with an embodiment of the present invention, and

Figure 11 is a cross-sectional view of a bipolar transistor produced on an Si wafer produced employing a method in accordance with an embodiment of the present invention.

In the following description, one example in accordance with each of the major embodiments of the present invention will be described, on the assumption that each example relates to an Si wafer produced employing the Czochralski method, which allows oxygen to remain in the Si wafer to a concentration in the range 0.5 to $2.0 \times 10^{18}/cm^3$.

Firstly, there will be described a method embodying the present invention for production of an Si wafer offering the intrinsic gettering effect, wherein the improvement of a considerably decreased production time is provided.

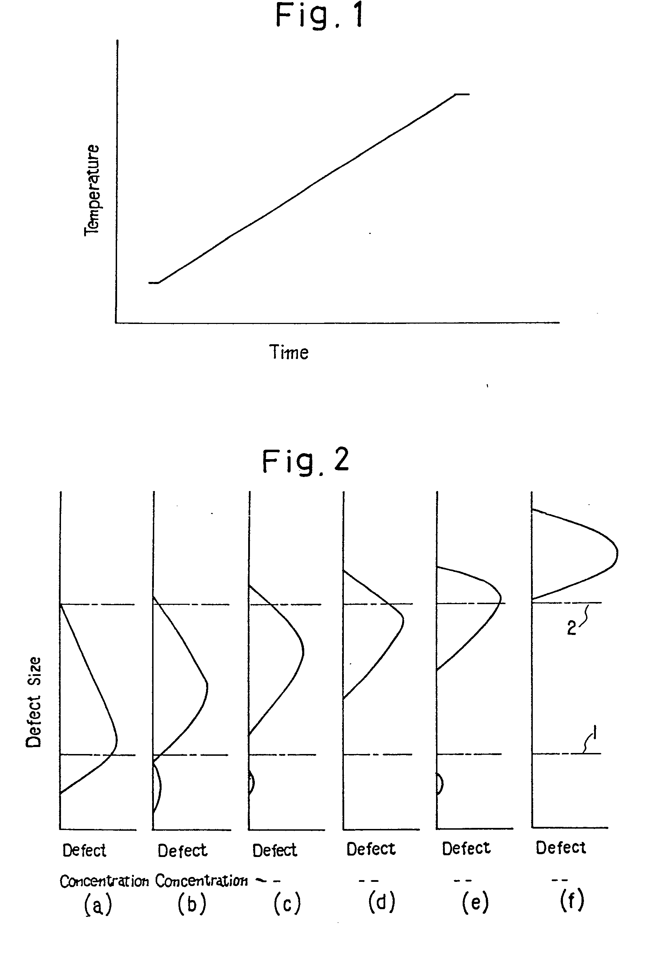

Referring to Figure 1, an Si wafer is subjected to one of more annealing processes in which the annealing temperature is increased from a low temperature, e.g. a temperature selected from the range 500 to 900°C, to a high temperature, e.g. a temperature selected from the range 950 to 1,300°C, at a predetermined rate which is a rate not exceeding 14°C/min.

The description given above of previously proposed methods indicates that any of those methods comprises a plurality of annealing steps carried out at respective different temperatures and each step having a different function. The method of the embodiment of the present invention illustrated by the graph of Figure 1 comprises an annealing step in which the annealing temperature is gradually increased and which has a plurality of functions, which functions are fulfilled in progression with the gradual increase in the annealing temperature. This is effective to eliminate transition periods, as a result decreasing overall process time.

Referring to Figure 2, graphs (a) to (f), which illustrate relationships between size and concentration of crystalline defects, or of nuclei thereof, located in a deep or internal region of an Si wafer in several exemplary phases of an annealing process of a method in accordance with one embodiment of the present invention, the progress of growth of crystalline defects of a larger size and which grow in a deep region of the Si wafer is described below.

Chain lines 1 and 2 in the graphs respectively indicate a first critical size of crystalline defects, of nuclei thereof, which are dismissed or destroyed by annealing at 750°C and a second critical size of crystalline defects, or nuclei thereof, which are observed after etching in a Preferential Wright Etching Solution.

Figure 2(a) illustrates that an as-grown Si wafer contains few nuclei having a size larger than the second critical size.

Figure 2(b) illustrates that, in an initial phase of an annealing process, or during the annealing process phase effected at a low temperature range, most of the nuclei grow to larger sizes and some of the nuclei grow into defects having sizes in excess of the second critical size and of which the existence can be detected by some methodology (for example by use of an etching method), and that a small quantity of nuclei having small sizes are born in the deep region or the internal region of the Si wafer.

Figure 2(c) illustrates that, in a middle phase of the annealing process, or during the annealing process phase effected at a middle temperature range, nuclei further grow to larger sizes following the increase in annealing temperature, and that the small quantity of nuclei of small size which were newly born during the initial phase are gradually dismissed or destroyed in the deep region or the internal region of the Si wafer. Incidentally, impurities such as oxygen diffuse out of the shallow region or the surface region of the Si wafer.

Figure 2(d) illustrates that, under a last phase of the annealing process, or during the annealing process phase effected at a high temperature range, the nuclei and defects further grow to large size and a considerable quantity of them grow into defects having sizes in excess of the second critical size in the deep or internal region of the Si wafer. Incidentally, by this time, a denuded zone has been produced in the shallow or surface region of the Si wafer. The higher the high temperature or the final temperature is, the larger the defect size is. Further, however, the higher the high temperature or the final temperature is, the larger the thickness of the denuded zone is, as a result decreasing the magnitude of the intrinsic gettering effect.

Figure 2(e) illustrates that, during an additional phase in which the annealing temperature is decreased, nuclei having sizes in excess of the first critical size go on growing to larger sizes, and that a small quantity of nuclei of small size are born in the deep or internal region of the Si wafer.

One part of these nuclei can be dismissed by repeated applications of the foregoing annealing process. The repeated application of the foregoing annealing process cannot be accompanied by the birth of new nuclei, in the surface region of the Si wafer, since the greater quantity of oxygen has been diffused out of the surface region of the Si wafer.

Figure 2(f) illustrates a condition achieved after application of the foregoing annealing process to an Si wafer a plurality of times. A number of defects having sizes in excess of the second critical size are available in the deep or internal region of the Si wafer and a denuded zone completely free from defects and/or nuclei thereof has grown in the surface or shallow region of the Si wafer.

The foregoing description makes it clear that, in a method in accordance with one embodiment of the present invention, nuclei of crystalline defects grow up to larger sizes, without change of the quantity or concentration thereof. In other words, all nuclei having a size not exceeding the first critical size are dismissed or destroyed and all defects and nuclei thereof having a size in excess of the first critical size grow to defects of a large size, enabling the Si wafer to possess a large intrinsic gettering effect.

Since the first critical size is determined by the lowest temperature in the annealing process, and also since the highest temperature or the final temperature is one of the major parameters which determine the thickness of a denuded zone, the magnitudes of the lowest temperature or the initial temperature and of the highest temperature or the final temperature are important parameters which determine the thickness of the denuded zone.

For the initial temperature, a lower temperature is preferable, and a temperature can be selected in the temperature range 500 to 900°C from the practical point of view.

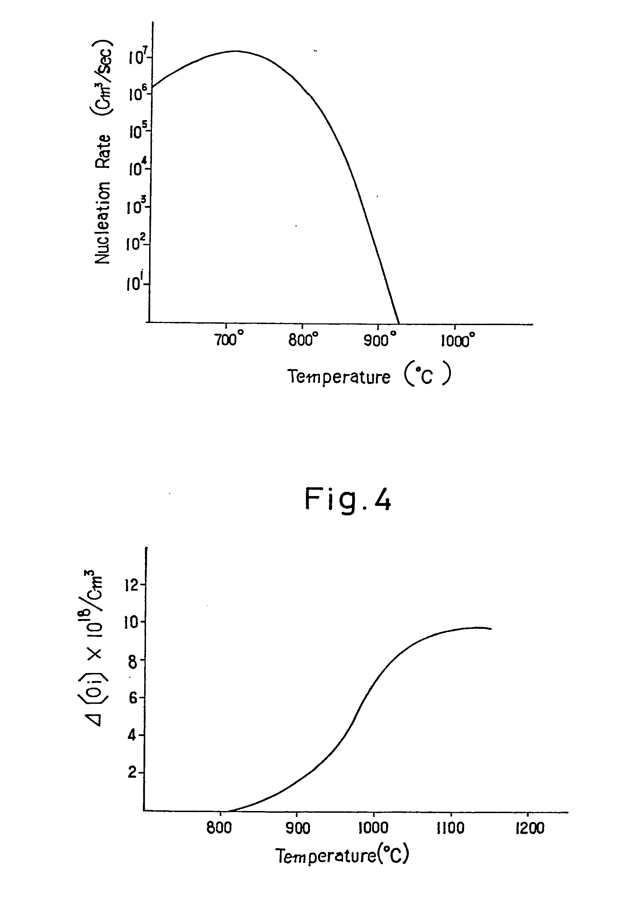

Figure 3 illustrates the relationship between nucleation rate and annealing temperature. Referring to Figure 3, a higher nucleation rate range is observed in the temperature range 650 to 850°C. Therefore, the initial temperature or the lowest temperature is preferably selected in the range 650 to 850°C.

As described earlier, a higher temperature produces a thicker denuded zone, decreasing the intrinsic gettering effect. From the practical point of view the final temperature or the highest temperature is preferably less than 1,300°C.

Figure 4 illustrates the relationship between decrease in oxygen concentration $\Delta$ [Oi] and annealing temperature T°C, the decrease being determined as results of a plurality of experimental annealings consisting of:— a first step in which an Si wafer having an initial oxygen concentration Oi of $1.8 \times 10^{18}/cm^3$ is annealed for 4 hours at 650°C; a second step in which the Si wafer is thereafter subjected to annealing in which the annealing temperature increases at a rate of 2°C/min. up to a temperature T°C; and a third step in which the Si wafer is further annealed for 3 hours at T°C. Referring to Figure 4, the temperature range in excess of 950°C is determined to be effective for growing crystalline defects. As a result, the final temperature or the highest temperature is preferably selected from the range of 950 to 1,300°C.

The most important parameter of an annealing process included in a method in accordance with this embodiment of the present invention is the temperature increase rate, which is the major parameter for determining the thickness of a denuded zone and the length of the period required for production of a denuded zone. Since the effect of temperature increase rate upon the thickness of the denuded zone varies depending upon the concentration of oxygen contained in an Si wafer, this effect will be discussed below.

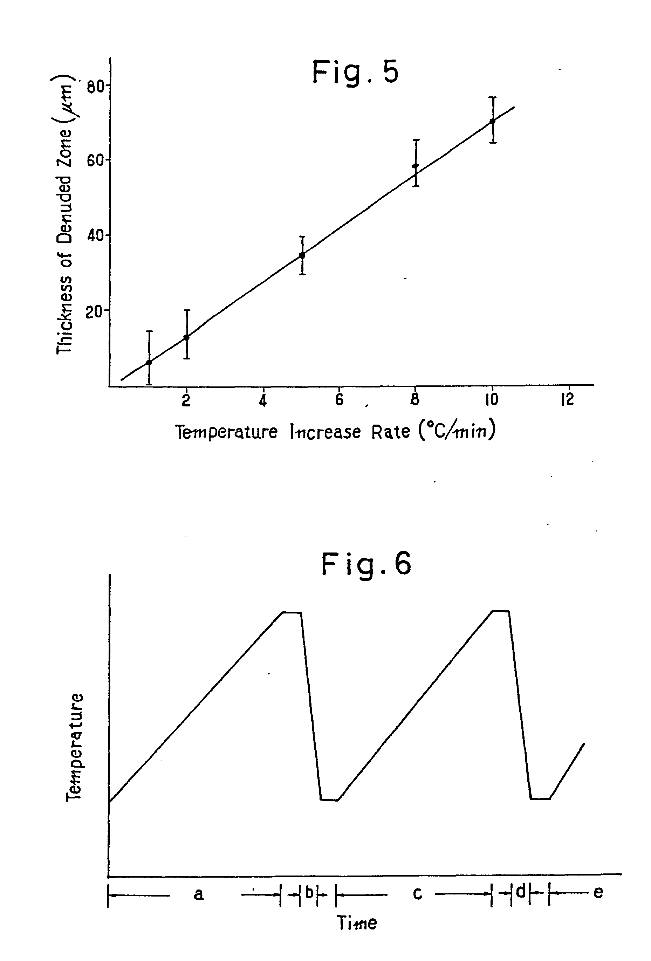

Figure 5 illustrates the relationship between thickness of denuded zone and annealing temperature increase rate for an Si wafer having an oxygen concentration in excess of $1.5 \times 10^{18}/cm^3$. Specifically, the graph shows the results of experiments effected for an Si wafer having an oxygen concentration of $1.8 \times 10^{18}/cm^3$, setting the initial or lowest temperature and the final or highest temperature respectively at 750°C and 1,100°C and setting an annealing time at the final or highest temperature at 30 minutes. Referring to Figure 5, lesser temperature increase rate produces a lesser thickness of denuded zone. The graph was produced by plotting intermediate thicknesses, in each case a thickness available between a defect free region and a region full of defects, which were determined by observation made after etching effected employing a Preferential Wright Etching Solution. As a result, the graph shows that a wafer having a denuded zone produced employing a temperature increase rate in the range 1 to 5°C/min. is not employable, because some of the defects are potentially located close to the surface of the wafer. Therefore, a method in accordance with this embodiment of the present invention, whenever applied to an Si wafer having an oxygen concentration in excess of $1.5 \times 10^{18}/cm^3$, should include at least one annealing process conducted at a temperature increase rate selected from the range 5 to 14°C/min. It was discovered that defects hardly grew in the deep or internal region of an Si wafer when an annealing is carried out at a temperature increase rate in excess of 14°C/min. It was also discovered that a lower temperature increase rate causes a higher concentration of the deep or internal defects.

It has been generally known or assumed that defects scarcely grow in any region of an Si wafer having an oxygen concentration not exceeding $1.5 \times 10^{18}/cm^3$. However, in fact, defects readily grow in the deep region or the internal region of an Si wafer having the oxygen concentration not exceeding $1.5 \times 10^{18}/cm^3$, when an annealing process is used having a temperature increase rate range not exceeding 5°C/min. As a result, it is concluded that a method in accordance with another embodiment of the present invention applicable to an Si wafer having the oxygen concentration not exceeding $1.5 \times 10^{18}/cm^3$, should include at least one annealing process to be conducted at a temperature increase rate range not exceeding 5°C/min. The employment of a plurality of annealing steps for one wafer is of course allowed. It is interesting that (slight, or insignificant) growth of defects occurs in embodiments of this invention even during a period in which the annealing temperature is decreased, albeit the growth rate is less than for a temperature increase period. This indicates the possibility of actively utilizing a temperature decrease period, when a plurality of annealing steps are employed, because the utilization of a temperature decrease process does not involve a requirement for an excessively long additional period of time in a case in which annealing processes are repeated a plurality of times in a single furnace.

Figure 6 illustrates temperature vs. time tendency of thermal cycles of a method in accordance with one embodiment of the present invention. Referring to Figure 6, a, b, c, d and e are the periods respectively of a first temperature increase process, a first temperature decrease process, a second temperature increase process, a second temperature decrease process and a third temperature increase process. The perferable relationships between the lengths of those periods are:

$$a \geq c \geq e \geq b \doteqdot d$$

As described earlier, the first temperature increase process is most important for the foregoing embodiment of the present invention. In other words, the second and later temperature increase processes are expected to increase the size of the nuclei which have been born during the first temperature increase process. Therefore, it is realistic to employ a temperature increase rate in accordance with the considerations discussed above for the foregoing embodiments for the first annealing process and to employ relatively larger temperature increase rates selected from the range not exceeding 14°C/min. for the second and later annealing processes, for the purpose of decreasing the overall length of time required for the annealing processes included in this method. It was determined that three or little more annealing processes are sufficient for production of an Si wafer having a good denuded zone. That is, a method comprising three annealing processes of which the lowest of initial temperature is 650°C, of which the temperature increase rate and the temperature decrease rate are 2°C/min. and of which the highest or final temperature is 1,100°C at which the temperature is maintained unchanged for 40 minutes, is effective to decrease the overall length of time required for the production of an Si wafer which utilizes the intrinsic gettering effect.

Features of embodiments, for example the foregoing embodiment, of the present invention can be summarized as follows:— a high concentration of crystalline defect nuclei is born during the low temperature period of a temperature increase process, and the high concentration of crystalline defect nuclei is allowed to grow into a high concentration of crystalline defects during the high temperature period of the temperature increase process, resulting in a high efficiency in, or the need for a lesser length of time for, production of an Si wafer which offers the intrinsic gettering effect. Repetition of the above-mentioned thermal processes is effective to control the average size of defect contained in the high concentration of crystalline defects. Longer periods of annealing at the high temperature and/or at the low temperature are or is effective to promote the efficient achievement of the desired results, albeit this is unnecessary in a case in which the high temperature is sufficiently high or the low temperature is sufficiently low.

An oxidizing gas can be used as the atmosphere in which such thermal processes are carried out. However, with regard to control of the thickness of a denuded zone it is preferable to use an inert gas.

It is effective for the initial high temperature annealing process to be carried out in an oxidizing gas and for the later processes to be conducted in an inert gas, because an $SiO_2$ film will have grown during the initial high temperature annealing process which will protect the Si wafer during the subsequent thermal processes.

When a protection film of $SiO_2$ is employed, the $SiO_2$ film also has the function of cleaning the surface of an Si wafer, when it is removed. Therefore, oxidation is preferable, rather than chemical vapour deposition, for production of such a protection film.

The foregoing description has made it clear that a considerable decrease in the overall length of time required for production is provided by a method for production of an Si wafer which offers the intrinsic gettering effect in accordance with an embodiment of the present invention.

There will be described below a method for production of an Si wafer having the intrinsic gettering effect, wherein better control of the thickness of a denuded zone, particularly in relation to a semiconductor wafer containing oxygen to a high concentration, is provided.

Specifically, this embodiment of the present invention enables a denuded zone to the produced in an Si wafer containing oxygen to a concentration in excess of $1.5 \times 10^{18}/cm^3$. As described above, the less is the temperature increase rate, the less is the thickness of a denuded zone. Incidentally, however, a lesser temperature increase rate causes crystalline defects to be produced in the shallow or surface region of an Si wafer containing oxygen to a high concentration, as a result giving rise to a drawback in that a lesser temperature increase rate cannot be employed for an Si wafer containing oxygen to a high concentration. This embodiment of the present invention avoids this drawback by application of an annealing process, to such an Si wafer containing oxygen to a high concentration, at a temperature in excess of 950°C for a period in excess of 10 minutes, prior to application of one or more annealing processes in which the annealing temperature is increased at a rate not exceeding 14°C/min., for the purpose of dismissing or destroying defect nuclei existing in the shallow or surface region of the wafer and to diffuse oxygen out of the shallow or surface region of the Si wafer. If the temperature increase rate is selected to be less than 5°C/min. for the initial phase, or for subsequent phases of the thermal processes which are effected while annealing temperature is being gradually increased, a thinner denuded zone is grown.

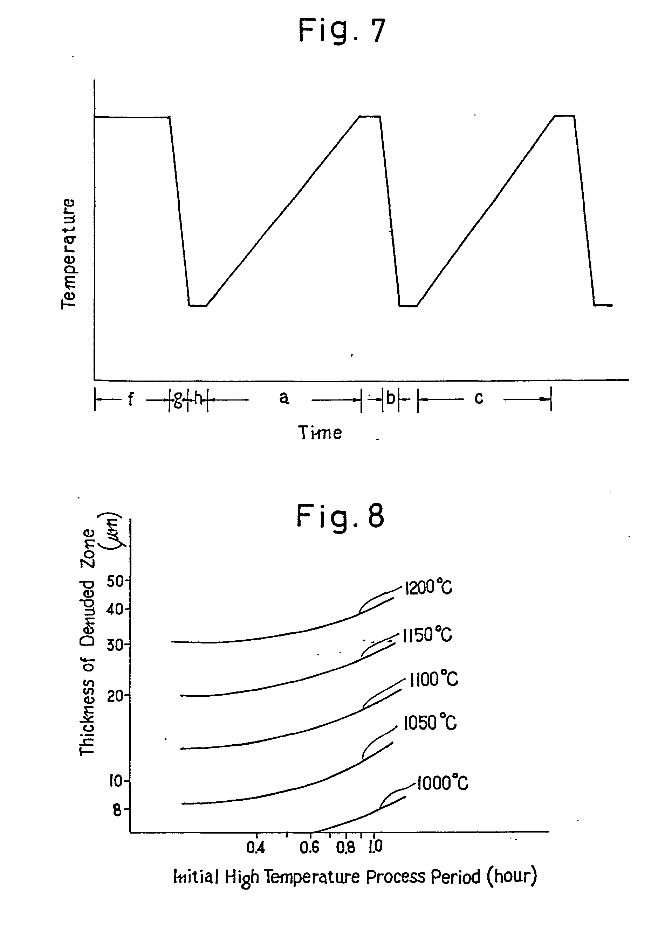

Figure 7 illustrates the temperature vs. time tendency of the thermal cycles of such a method embodying the present invention. Referring to Figure 7, f is a period in which an Si wafer is annealed for 60 minutes at 1,100°C for the purpose of dismissing or destroying crystalline defect nuclei in the shallow or surface region of the Si wafer and of diffusing oxygen out of the shallow or surface region. It is noted that the annealing temperature is required to be in excess of 950°C to be effective for the foregoing purposes. On the other hand, the temperature is required to be less than 1,300°C if buckling of the Si wafer is to be avoided. The annealing period should exceed 10 minutes. A preferred length for the period is 60 minutes. The Si wafer is preferably covered by an $SiO_2$ protection film during this thermal process. It is possible to grow an $SiO_2$ film during this thermal process rather than to use an Si wafer which is covered by an $SiO_2$ film at the commencement of the process.

g is a period in which the annealing temperature is decreased to 650°C. Since this process step has little effect on the function the provision of which is the major object of this embodiment of the present invention, no particular consideration need be given to period g. In other words, an abrupt decrease in temperature can be effected during period g.

h is a period in which the Si wafer is annealed, for a time from 0 to 15 hours, at 650°C. Since such annealing has little ultimate effect it can be eliminated.

a is a period in which annealing temperature is increased at a rate of 2°C/min. from 650°C to 1,100°C. Since the criteria which govern the formation of a denuded zone are determined in this period and in initial high temperature treatment time, this period sets the most important parameters which establish the limitations for this embodiment of the present invention. A temperature increase rate not exceeding 5°C/min. allows a denuded zone having the thickness of 10 through 30 micrometers to grow on an Si wafer having a relatively high oxygen concentration in excess of $1.5 \times 10^{18}/cm^3$. One or two cycles of temperature increase at a rate of 1 to 3°C/min. or three cycles of temperature increase at a rate of 3 to 5°C/min. have been determined to be satisfactory for production of an Si wafer.

A method in accordance with this embodiment of the present invention is not effective to produce a denuded zone in an Si wafer having an oxygen concentration not exceeding $1.5 \times 10^{18}/cm^3$, albeit that it is effective to clean the surface of a wafer, regardless of the magnitude of oxygen concentration. It is to be noted that a longer low temperature annealing period, h in Figure 7, enables a method in accordance with this embodiment of the present invention to produce a denuded zone in an Si wafer having a lesser oxygen concentration. An experimental result shows that a low temperature annealing carried out for 2 hours at e.g. 650°C is sufficient for this purpose.

Figure 8 is a graph illustrating relationships between thickness of a denuded zone and length of the initial high temperature annealing period, with annealing temperature as a parameter.

Figure 8 shows results obtained using an experimental process consisting of an initial high temperature annealing effected at a temperature in the range 1,000 to 1,200°C, a temperature decrease period in which temperature is decreased to 650°C at a rate of 5°C/min., a low temperature annealing lasting for 3 hours at 650°C, a temperature increase period in which temperature is increased from 650°C to 1,100°C at a rate of 2°C/min., a high temperature annealing effected for 0.5 hours at 1,100°C, and a temperature decrease period in which temperature is decreased from 1,100°C to 650°C at a rate of 5°C/min.

From Figure 8 it will be seen that a higher initial annealing temperature results in a greater thickness of denuded zone. A longer initial annealing period also results in a greater thickness of denuded zone. This means that the thickness of a denuded zone can be controlled by the temperature or the duration of an initial annealing process.

It is preferable that an Si wafer be covered by a protection film, e.g. an $SiO_2$ film, during thermal processes. However, rather than separately providing such a protection film, an oxidizing gas can be employed for the atmosphere in which thermal processes are carried out so that the surface of the Si wafer is protected by an $SiO_2$ film which grows on the Si wafer during the thermal processes, albeit that the employment of an inert gas is preferable from the point of view of the control of the thickness of a denuded zone. Therefore, it is effective to effect the initial high temperature annealing process in an oxidizing gas and to effect later processes in an inert gas, because an $SiO_2$ film will have grown during the initial high temperature annealing process.

The foregoing description has made it clear that better control of the thickness of a denuded zone, particularly for an Si wafer having a high concentration of oxygen, can be provided in a method for production of an Si wafer having the intrinsic gettering effect in accordance with an embodiment of the present invention.

A method embodying the present invention will now be described which is effective to maintain a denuded zone once produced in an Si wafer, even during later thermal processes involved in production of a semiconductor device, and also effective to inhibit warpage of a seminconductor wafer during thermal processes involved in production of a semiconductor device.

An Si wafer is inevitably exposed to high temperatures in excess of 950°C during processes involved in the production of a semiconductor device, because the processes include impurity diffusion, oxidation, et al. An intrinsic gettering effect is preferably utilized during these processes. However, a denuded zone once produced in an Si wafer is often dismissed or destroyed during processes for production of a semiconductor device. The object of this embodiment of the present invention is to inhibit dismissal or destruction of a denuded zone produced in an Si wafer, during processes for production of a semiconductor device, as a result allowing the intrinsic gettering effect to function well.

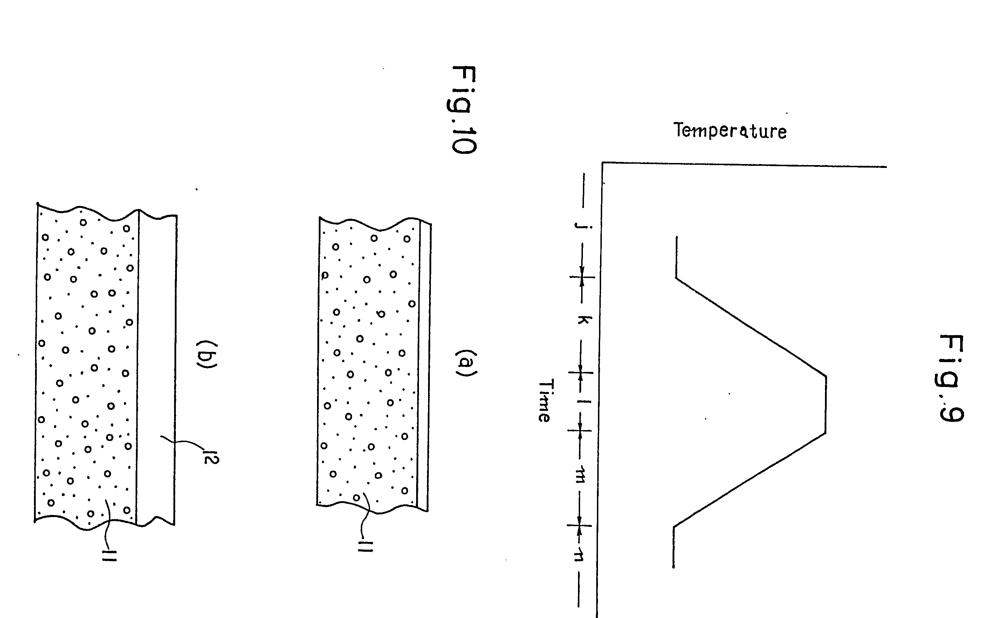

Figure 9 illustrates the temperature vs. time tendency of the thermal cycles of a method in accordance with this embodiment of the present invention applied to a process for production of a gate oxide film of a MOS transistor. Referring to Figure 9, j, k, l, m and n are, respectively, a low temperature annealing period in which an Si wafer is annealed for 7 minutes at 900°C, a temperature increasing process in which the temperature is increased to 1,050°C at a rate of 10°C/min., a high temperature annealing period in which the Si wafer is annealed for 10 minutes at 1,050°C, a temperature decreasing process in which the temperature is decreased to 900°C at a rate of 5°C/min., and a low temperature period at the temperature of 900°C. After the temperature has been decreased to 900°C, the Si wafer is taken out of a furnace. By this process, a gate oxide film having the thickness of 350 through 400 angstroms is produced. Since the object of this process is oxidation, the atmosphere is dry oxygen.

In this embodiment of the present invention both a temperature increase period and a temperature decrease period are utilized and a significant temperature gap is required between the high temperature and the low temperature. Therefore, the low temperature can be selected to be in the range 500 to 900°C, preferably in the range 600 to 700°C, and the high temperature can be selected to be in the range of 950 to 1,300°C. The preferable temperature increase rate, and the preferable temperature decrease rate, is 14°C/min., because delay in heat tramsmission must be taken into account. This embodiment of the present invention offers a reduction in process time at a temperature higher than 1,000°C, and provides for maintenance of crystalline defects in the deep region of an Si wafer, with a selected temperature increase rate and a selected temperature decrease rate such as not to cause dismissal or destruction of crystalline defects available in the deep region of an Si wafer. It is required to select a temperature increase rate in the range of 5°C/min. to 14°C/min., particularly in a case in which the Si wafer contains a large quantity or large concentration of oxygen. Since both a temperature increase process and a temperature decrease process function only in a positive direction insofar as the growth of a denuded zone is concerned, it is possible to apply this embodiment of the present invention to a process for production of a semiconductor device which contains an annealing step effected at a temperature higher than 950°C, for the purpose of utilizing the denuded zone which was produced in an earlier phase of the process for production of a semiconductor device.

Further, it is possible to apply this embodiment of the present invention to an Si wafer wherein no denuded zone has yet been produced, since a new denuded zone can be produced by the process in accordance with this embodiment.

The foregoing description has made it clear that a method embodying the present invention can be provided which is effective to maintain a denuded zone once produced in an Si wafer, even during a later thermal process involved in processes for production of a semiconductor device, and which is also effective to inhibit warpage of a semiconductor wafer during the thermal processes for production of a semiconductor device.

A method embodying the present invention will now be described for production of a semiconductor wafer which offers the intrinsic gettering effect, or of a semiconductor wafer having a shallow or surface region which is a denuded zone and a deep or internal region containing a high concentration of crystalline defects large in size, such that the semiconductor wafer offers an intrinsic gettering effect which is improved and which as a result can be employed in the production of a bipolar semiconductor device.

The description given above has made it clear that an efficient intrinsic gettering effect can be provided to produce and maintain a denuded zone in the shallow or surface region of an Si wafer with a high concentration of crystalline defects in the deep or internal region of the same Si wafer. An Au diffusion process is available which has a similar function to the intrinsic gettering effect insofar as a bipolar semiconductor device is concerned. In order to allow the provision of a intrinsic gettering effect to replace the Au diffusion process, it is essential to produce a denuded zone having a thickness of 1 to 2 micrometers.

Each of the methods for production of an Si wafer which possesses the intrinsic gettering effect, or an Si wafer having a shallow or surface region of a denuded zone and a deep or internal region containing a high concentration of crystalline defects, is based on annealing processes. Albeit such methods based on annealing processes are convenient particularly from the point of view of practical production, some limitations are observed more or less from the point of view of functions of devices produced using those methods. The present embodiment of this invention can remove limitations of this type which are detrimental particularly with regard to bipolar transistors.

A method in accordance with this embodiment of the present invention includes a first step in which an Si wafer is annealed employing a process in which the annealing temperature increases at a rate not exceeding 5°C/min., and a second step in which an epitaxial layer containing one or more impurities of one conductivity type and having a thickness in excess of 2 micrometers is grown on the Si wafer.

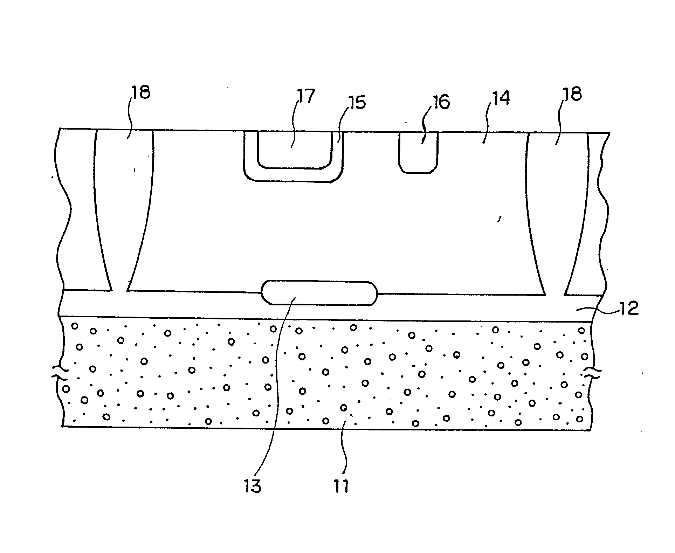

Referring to Figure 10(a), an Si wafer 11 containing oxygen to a concentration of e.g. $2 \times 10^{18}/cm^2$ is annealed, annealing temperature being increased from 750°C to 1,100°C at a rate of 2°C/min. As described above, the most important parameter in determining the thickness of a denuded zone is the temperature increase rate in the initial or first temperature increase phase. An initial temperature increase rate of 2°C/min. enables crystalline defects to be produced up to immediately below the surface of the Si wafer. Thereafter, the Si wafer is annealed for 30 minutes at 1,100°C. The length of time taken for this high temperature annealing process is preferably approximately 30 minutes, otherwise some of the crystalline defects which have not yet grown to a size larger than a critical magnitude will readily be dismissed. After completion of this high temperature annealing process, the annealing temperature is decreased from 1,100°C to 750°C at a rate of 5°C/min. In a case in which a tendency is observed for oxygen concentration of an Si wafer to determine whether or not crystalline defects can be produced up to immediately below the surface of the Si wafer, a plurality of applications of the foregoing first step is effective to produce crystalline defects just close to the surface of the Si wafer. For an Si wafer containing oxygen to a concentration of $2 \times 10^{18}/cm^3$, two applications of the foregoing first step are sufficient for this purpose.

Referring to Figure 10(b), after the Si wafer has been exposed to fluoric acid to remove an $SiO_2$ film grown in the previous process, an exptaxial layer 12 is grown to a thickness in the range 3 to 4 micrometers, in the case of bipolar transistors, or a thickness in the range of 2 to 3 micrometers, in the casxe of MOS devices. Due to the intrinsic gettering effect caused by the high concentration of crystalline defects produced in the previous process, the epitaxial layer 12 is converted to a denuded zone.

Referring to Figure 11, the following series of processes is required for production of a bipolar transistor employing the Si wafer of Figure 10(b). A buried layer 13, of Si containing impurities of one conductivity type, is provided before a second epitaxial layer or a collector 14, of Si containing impurities of the same conductivity type as the impurities of the buried layer 13, is grown on the first epitaxial layer 12. Thereafter, a collector terminal 16 having a conductivity type the same as that of the collector 14 and a base 15 having a conductivity type different from that of the collector 14 are produced in the collector 14 by means of impurity diffusion. An emitter 17 having a conductivity type different from that of the base 15 is produced in the base 15 by means of impurity diffusion. When necessary, elements are insulated from one another by a region 18 having a conductivity type different from that of the collector 14. In this case, the first epitaxial layer 12 is required to have a conductivity type different from that of the buried layer 13.

The foregoing redundant series of processes provides an extremely large thickness of active layers 12 and 14, as a result decreasing the function of the intrinsic gettering effect. However, it is possible to produce a buried layer before the first epitaxial layer is grown on a region containing a large quantity of crystalline defects. This possibility potentially involves a risk that the buried layer will be connected with the region containing a large quantity of crystalline defects which would result in leakage therebetween. In order to remove this drawback, a modification is available which includes a first step in which a semiconductor wafer is annealed, with the annealing temperature increasing at a rate not exceeding 5°C/min., a second step in which a thin epitaxial layer is provided containing impurities of one conductivity type, before a buried layer is produced, and a third step in which an epitaxial layer containing impurities of one conductivity type and having a thickness in excess of 2 micrometers is grown on the epitaxial layer previously produced.

The foregoing description makes it clear that a method for production of an Si wafer which allows an improved degree of the intrinsic gettering effect than is available from any of the methods based on an annealing process is realized in a method in accordance with this embodiment of the present invention.

The present invention provides a variety of methods applicable to production of semiconductor devices of which an active layer is produced in a denuded zone which is thin and free of defects and which therefore, in combination with a high concentration of crystalline defects contained in the deep layer of the semiconductor device, allows the semiconductor device to enjoy the function of the intrinsic gettering effect.

A variety of improvements including decrease in overall production time, removal of limitations due to the oxygen concentration of a wafer, et al. are achieved by employment of processes in which annealing temperature is increased and/or decreased gradually at a predetermined rate, a variety of such improved annealing processes being combined with each other and/or with a variety of conventional annealing processes, to achieve a higher degree of intrinsic gettering effect. Such improvements can be further modified to be combined with epitaxy to diversify the uses of a denuded zone.

## Claims

1. A method for production of a semiconductor device possessed of the intrinsic gettering effect, the method of comprising annealing a silicon wafer, characterised in that at least one annealing process is effected in which annealing temperature is increased from a first temperature in the range 500°C to 900°C to a second temperature in the range 950°C to 1,300°C, at a rate not exceeding 14°C/min.

2. A method as claimed in claim 1, wherein the silicon wafer contains oxygen to a concentration in excess of $1.5 \times 10^{18}/cm^3$ and the or the first such annealing process is effected at a temperature increase rate in the range 5 to 14°C/min.

3. A method as claimed in claim 1, wherein the silicon wafer contains oxygen to a concentration not exceeding $1.5 \times 10^{18}/cm^3$ and the or the first such annealing process is effected at a temperature increase rate not exceeding 5°C/min.

4. A method as claimed in claim 1, wherein the silicon wafer contains oxygen to a concentration in excess of $1.5 \times 10^{d\ 18}/cm^3$, the method further comprising, prior to the or the first such annealing process, a step in which the silicon wafer is annealed at a temperature in excess of 950°C for a period in excess of 10 minutes.

5. A method as claimed in claim 4, wherein the or the first such annealing process is effected at a temperature increase rate not exceeding 5°C/min.

6. A method as claimed in claim 1, for production of a semiconductor device employing a silicon wafer having a shallow or surface region which is a denuded zone and also having a deep or internal region, underlying the shallow or surface region, containing a high concentration of crystalline defects large in size, wherein after the or the first such annealing process, in which the temperature increase rate is in the range 5 to 14°C/min., a further annealing process is effected in which the annealing temperature is decreased from the said second temperature to the said first temperature at a temperature decrease rate in the range 5 to 14°C/min.

7. A method as claimed in claim 1, wherein the silicon wafer contains oxygen to a concentration in excess of $1.5 \times 10^{18}/cm^3$, wherein the said at least one annealing process is effected such that annealing temperature is increased at a rate not exceeding 5°C/min., and wherein, after the annealing, a silicon epitaxial layer containing at least one impurity, having one conductivity type, and having a thickness in excess of 2 micrometers, is grown on the silicon wafer.

8. A method as claimed in claim 7, wherein the said second temperature is approximately 1,100°C.

9. A method as claimed in claim 7 or 8, wherein the temperature increase rate in the or the first such annealing process is not larger than the temperature increase rate of any subsequent such annealing process.

10. A method as claimed in claim 1, for production of a bipolar transistor, wherein the silicon wafer contains oxygen to a concentration in excess of $1.5 \times 10^{18}/cm^3$, wherein the said at least one annealing process is conducted under the condition that annealing temperature is increased at a rate not exceeding 5°C/min., and thereafter a thin silicon epitaxial layer containing at least one impurity, having one conductivity type, is grown on the silicon wafer, then at least one impurity, having the said one conductivity type, is introduced in a high concentration into a selected region of the top portion of the thin silicon epitaxial layer for the purpose of producing a buried layer, and then a silicon epitaxial layer containing at least one impurity, having the said one conductivty type, and having a thickness in excess of 2 micrometers, is grown on the thin silicon epitaxial layer.

11. A method as claimed in claim 10, wherein the said second temperature is approximately 1,100°C.

12. A method as claimed in claim 10 or 11, wherein the temperature increase rate in the or the first such annealing process is not larger than the temperature increase rate in any subsequent such annealing process.

## Patentansprüche

1.Verfahren zur Herstellung einer Halbleitervorrichtung mit einem eigenleitenden Gettereffekt, welches Verfahren die Ausheilung eines Siliciumwafers umfaßt, dadurch gekennzeichnet, daß wenigstens ein Ausheilungsprozeß bewirkt wird, bei dem die Ausheilungstemperatur von einer ersten Temperatur um Bereich von 500°C bis 900°C auf eine zweite Temperatur im Bereich von 950°C bis 1300°C erhöht wird, mit einer Geschwindigkeit, die 14°C/min nicht überschreitet.

2. Verfahren nach Anspruch 1, bei dem das Siliciumwafer Sauerstoff in einer Konzentration oberhalb $1,5 \times 10^{18}/cm^3$ enthält, und der oder der erste solche Ausheilungsprozen bei einer Temperaturanstiegsgeschwindigkeit im Bereich von 5 bis 14°C/min bewirkt wird.

3. Verfahren nach Anspruch 1, bei dem das Siliciumwafer Sauerstoff in einer Konzentration nicht oberhalb $1,5 \times 10^{18}/cm^3$ enthält, und der oder der erste solche Ausheilungsprozeß bei einer Temperaturanstiegsgeschwindigkeit nicht oberhalb 5°C/min bewirkt wird.

4. Verfahren nach Anspruch 1, bei dem das Siliciumwafer Sauerstoff in einer Konzentration

oberhalb $1,5 \times 10^{18}/cm^3$ enthält, welches Verfahren ferner, vor dem oder dem ersten solchen Ausheilungsprozeß, einen Schritt umfaßt, bei dem das Siliciumwafer bei einer Temperatur oberhalb 950°C während einer Periode von mehr als 10 Minuten ausgeheilt wird.

5. Verfahren nach Anspruch 4, bei dem der oder der erste solche Ausheilungsprozeß bei einer Temperaturanstiegsgeschwindigkeit nicht oberhalb 5°C/min durchgeführt wird.

6. Verfahren nach Anspruch 1, zur Herstellung einer Halbleitervorrichtung, die ein Siliciumwafer verwendet, welches einen flachen oder Oberflächenbereich hat, der eine entblößte Zone ist, und auch einen tiefen oder inneren Bereich hat, der unter dem flachen oder Oberflächenbereich liegt und eine hohe Konzentration von Kristalldefekten großer Größe hat, wobei nach dem oder dem ersten solchen Ausheilungsprozeß, bei dem die Temperaturzuwachsgeschwindigkeit im Bereich von 5 bis 14°C/min liegt, ein weiterer Ausheilungsprozeß bewirkt wird, bei dem die Ausheilungstemperatur von der genannten zweiten Temperatur auf die genannte erste Temperatur mit einer Temperaturabnahmegeschwindigkeit im Bereich von 5 bis 14°C/min erniedrigt wird.

7. Verfahren nach Anspruch 1, bei dem das Siliciumwafer Sauerstoff in einer Konzentration oberhalb $1,5 \times 10^{18}/cm^3$ enthält, wobei der genannte wenigstens eine Ausheilungsprozeß so bewirkt wird, daß die Ausheilungstemperatur mit einer Geschwindigkeit nicht oberhalb 5°C/min erhöht wird, und bei dem, nach der Ausheilungsbehandlung, eine epitaktische Siliciumschicht, welche wenigstens eine Verunreinigung, die von einem Leitfähigkeitstyp ist, enthält und eine Dicke größer als 2 Mikrometer hat, auf das Siliciumwafer aufgewachsen wird.

8. Verfahren nach Anspruch 7, bei dem die genannte zweite Temperatur etwa 1100°C beträgt.

9. Verfahren nach Anspruch 7 oder 8, bei dem die Temperaturanstiegsgeschwindigkeit bei dem oder dem ersten Ausheilungsprozeß nicht größer als die Temperaturanstiegsgeschwindigkeit von irgendeinem folgenden solchen Ausheilungsprozeß ist.

10. Verfahren nach Anspruch 1, zur Herstellung eines bipolaren Transistors, bei dem das Siliciumwafer Sauerstoff in einer Konzentration oberhalb $1,5 \times 10^{18}/cm^3$ enthält, bei dem der genannte wenigstens eine Ausheilungsprozeß unter der Bedingung durchgeführt wird, daß die Ausheilungstemperatur mit einer Geschwindigkeit nicht oberhalb 5°C/min erhöht wird, und danach eine dünne epitaktische Siliciumschicht, die wenigstens eine Verunreinigung enthält, die einen Leitfähigkeitstyp hat, auf das Siliciumwafer aufgewachsen wird, dann wenigstens eine Verunreinigung, welche diesen genannten einen Leitfähigkeitstyp hat, in einer hohen Konzentration in einen ausgewälten Bereich auf den oberen Abschnitt der dünnen epitaktische Siliciumschicht eingeführt wird, zu dem Zwecke der Erzeugung einer vergrabenen Schicht, und dann eine epitaktischen Siliciumschicht, die wenigstens eine Verunreinigung enthält, welche den genannten einen Leitfähigkeitstyp hat und welche eine Dicke oberhalb von 2 Mikrometern hat, auf die dünne epitaktische Siliciumschicht aufgewachsen wird.

11. Verfahren nach Anspruch 10, bei dem die genannte zweite Temperatur etwa 1100°C beträgt.

12. Verfahren nach Anspruch 10 oder 11, bei dem die Temperaturanstiegsgeschwindigkeit in dem oder dem ersten solchen Ausheilungsprozeß nicht größer als die Temperaturanstiegsgeschwindigkeit in irgendeinem folgenden solchen Ausheilungsprozeß ist.

**Revendications**

1. Un procédé de production d'un dispositif à semiconducteur ayant l'effet getter intrinsèque, ledit procédé comprenant le recuit d'une pastille de silicium, caractérisé en ce que l'on conduit au moins un procédé de recuit selon lequel la température de recuit est augmentée depuis une première température comprise dans l'intervalle de 500°C à 900°C jusqu'à une seconde température comprise dans l'intervalle de 950°C à 1,300°C, à un taux ne dépassant pas 14°C/min.

2. Un procédé selon la revendication 1, selon laquelle la pastille de silicium contient de l'oxygène à une concentration supérieure à $1,5 \times 10^{18}/cm^3$ et le ou le premier procédé de recuit est effectué à un taux d'accroissement de la température compris dans l'intervalle de 5 à 14°C/min.

3. Un procédé selon la revendication 1, selon laquelle la pastille de silicium contient de l'oxygène à une concentration ne dépassant pas $1,5 \times 10^{18}/cm^3$ et le ou le premier procédé de recuit est effectué à un taux d'accroissement de température ne dépassant pas 5°C/min.

4. Un procédé selon la revendication 1, selon laquelle la pastille de silicium contient de l'oxygène à une concentration supérieure à $1,5 \times 10^{18}/cm^3$, le procédé comprenant en outre, avant le ou le premier procédé de recuit, une étape dans laquelle la pastille de silicium est recuite à une température supérieure à 950°C pendant une période de temps supérieure à 10 min.

5. Un procédé selon la revendication 4, selon laquelle le ou le premier procédé de recuit est effectué à un taux d'accroissement de température ne dépassant pas 5°C/min.

6. Un procédé selon la revendication 1, pour la production d'un dispositif à semi-conducteur employant une pastille de silicium ayant une région peu profonde ou de surface qui est une zone dénudée et ayant également une région profonde ou interne, sous-jacente à a la région peu profonde ou de surface, contenant une concentration élevée en défauts cristallins de grande taille, procédé selon lequel, après le ou le premier procédé de recuit, dans lequel le taux d'accroissement de température est compris dans l'intervalle de 5 à 14°C/min, un autre procédé de recuit est effectué dans lequel la température de recuit est diminuée depuis ladite seconde température jusqu'à ladite première température à un taux de diminution de température dans l'intervalle de 5 à 14°C/min.

7. Un procédé selon la revendication 1, selon laquelle la pastille de silicium contient de l'oxygène à une concentration supérieure à $1,5 \times 10^{18}$/cm³, et selon laquelle ledit au moins un procédé de recuit est effectué de façon que la température de recuit augmente à un taux ne dépassant pas 5°C/min, et selon laquelle, après le recuit, une couche épitaxiale de silicium contenant au moins une impureté, ayant un type de conductivité, et ayant une épaisseur supérieure à 2 micromètres est formée par croissance sur la pastille de silicium.

8. Un procédé selon la revendication 7, selon laquelle ladite seconde température est d'environ 1,100°C.

9. Un procédé selon la revendication 7 ou 8, selon laquelle le taux d'accroissement de température dans le ou le premier procédé de recuit n'est par supérieur au taux d'accroissement de température d'un procédé de recuit subséquent quelconque.

10. Un procédé la revendication 1, pour la production d'un transistor bipolaire, selon laquelle la pastille de silicium contient de l'oxygène à une concentration supérieure à $1,5 \times 10^{18}$/cm³, ledit au moins un procédé de recuit est conduit dans la condition selon laquelle la température de recuit est augmentée à un taux ne dépassant pas 5°C/min, et ensuite une couche épitaxiale mince de silicium contenant au moins une impureté, ayant un type de conductivité, est formée par croissance sur la pastille de silicium, puis au moins une impureté, ayant un même type de conductivité, est introduite à une concentration élevée dans la région sélectionée de la portion de dessus de la couche épitaxiale mince de silicium en vue de produire une couche enterrée, et ensuite une couche épitaxiale de silicium contenant au moins une impureté, ayant un même type de conductivité, et ayant une épaisseur supérieure à 2 micromètres est formée par croissance sur la couche épitaxiale mince de silicium.

11. Un procédé selon la revendication 10, selon laquelle ladite seconde température est d'environ 1,1000°C.

12. Un procédé selon la revendication 10 ou 11, selon laquelle le taux d'accroissement de température dans le ou le premier procédé de recuit n'est pas supérieur au taux d'accroissement de température dans un procédé de recuit subséquent quelconque.

# Fig. 1

# Fig. 2

Fig.4

## Fig. 5

Thickness of Denuded Zone (μm) vs Temperature Increase Rate (°C/min)

## Fig. 6

Temperature vs Time

a   b   c   d   e

# Fig. 7

# Fig. 8

# Fig.9

# Fig.10

(a)

(b)